# EUROPEAN PATENT SPECIFICATION

(11) **EP 2 146 438 B1**
(45) Date of publication and mention of the grant of the patent: **11.02.2015**
(21) Application number: 08160458.9
(22) Date of filing: 15.07.2008
(51) Int. Cl.: H04B 1/04, H04B 15/04

(54) **Mobile wireless communication device with separate in-phase and quadrature power amplification**
Mobile drahtlose Kommunikationsvorrichtung mit separater In-Phase- und Quadraturverstärkung
Dispositif de communication mobile sans fil avec séparation en phase et amplification d'alimentation de quadrature

(43) Date of publication of application: 20.01.2010
(73) Proprietor: BlackBerry Limited, Waterloo, ON N2K 0A7 (CA)
(72) Inventor: Mankaruse, George, Kitchener, Ontario, N2P 2Y2 (CA); Zhu, Lizhong, Waterloo, Ontario, N2T 2T8 (CA); Corrigan, Michael, Waterloo, Ontario, N2T 1S5 (CA); Jarmuszewski, Perry, Waterloo, Ontario, N2V 2R6 (CA)
(74) Representative: Hibbert, Juliet Jane Grace

(56) References cited:
- US-A1- 2005 226 340
- US-A1- 2006 006 946

## Description

### Field of the Invention

The present invention relates to the field of communications devices, and more particularly, to mobile wireless communications devices and related methods.

### Background of the Invention

Cellular communication systems continue to grow in popularity and have become an integral part of both personal and business communications. Cellular telephones allow users to place and receive phone calls most anywhere they travel. Moreover, as cellular telephone technology is increased, so too has the functionality of cellular devices. For example, many cellular devices now incorporate Personal Digital Assistant (PDA) features such as calendars, address books, task lists, calculators, memo and writing programs, etc. These multi-function devices usually allow users to send and receive electronic mail (email) messages wirelessly and access the internet via a cellular network and/or a wireless local area network (WLAN), for example.

As the functionality of cellular communications devices continues to increase, so too does demand for smaller devices that are easier and more convenient for users to carry. The circuit boards and associated electronic components thereon are becoming increasingly reduced in size and placed closer together. These components include antennae, RF components, power amplifiers, antenna switches, and other electronic components that pick up conductive energy and create interference within various circuits and components. For example, some components could pick up conducted energy directly from a power amplifier circuit, the charging contacts of a battery, antenna contacts, or from the radiated energy emitted by an antenna. This unwanted reception of conducted or near field radiated energy from power amplifiers, antennae or other components is particularly problematic in a packet burst transmission as part of a Global System for Mobile communications (GSM) system, including the 450 MHz, 900 MHz, 1800 MHz and 1900 MHz frequency bands. Other issues arise with modulation schemes that use In-phase (I) and Quadrature (Q) circuits, creating linearity issues with power amplifiers and poor antenna match. This can cause degradation of TRP (total radiated power) and raise harmonic interference issues because of the higher nonlinearity of a power amplifier as an example.

US patent application no. US 2006/006946 (A1) relates to a power amplifier assembly having a first power amplifier with a first input conditioning circuit. At least first and second amplifiers are in parallel with each other and having inputs and outputs. An input signal is coupled to the inputs of the first and second amplifiers. A first multi-input power combiner is provided. The outputs of the at least first and second parallel amplifiers are combined by the first multi-input power combiner to add signals of the outputs constructively. A second power amplifier has a first input conditioning circuit. At least first and second amplifiers are in parallel with each other and having inputs and outputs. An input signal is coupled to the inputs of the first and second amplifiers. A second multi-input power combiner is provided. The outputs of the at least first and second parallel amplifiers are combined by the second multi-input power combiner to add signals of the outputs constructively.

US patent application no. US 2005226340 (A1) relates to a system for electromagnetic processing of an input wave involving the steps of receiving a modified signal derived from two or more signals that represent the input wave when combined; and regulating the modified signal using a digital signal containing at least one characteristic of the two or more signals. Embodiments of the invention may utilize in-phase and quadrature phase signals, where the magnitude portion of the signals may be used for regulating the modified signal. The modified signal may be created by modulating a characteristic of the I, Q signals, such as their sign, with an RF or other frequency carrier wave

### Summary of the Invention

A mobile wireless communications device includes a housing and antenna mounted within the housing. Radio frequency (RF) circuitry is carried within the housing, such as typically on at least one circuit board, and includes a transceiver connected to the antenna through which RF communication signals are transmitted and received. A processor is operative with the RF circuitry. A transceiver includes an In-phase and Quadrature (I/Q) Modulation and Power Amplification circuit. An In-phase (I) circuit has an In-phase signal input, an In-phase modulator mixer, an In-phase power amplifier circuit that receives the In-phase signal and amplifies the In-phase signal and an In-phase controller connected to the output of the In-phase power amplifier circuit and operative in a closed loop manner with the In-phase power amplifier circuit to control biasing in the In-phase power amplifier circuit and to adjust the amplitude of the In-phase signal. A Quadrature "Q" circuit comprises a Quadrature signal input, a Quadrature modulator mixer, a Quadrature power amplifier circuit that receives the Quadrature signal and amplifies the Quadrature signal and a Quadrature controller connected to the output of the Quadrature power amplifier circuit and operative in a closed loop manner with the Quadrature power amplifier circuit to control biasing in the Quadrature power amplifier circuit and to adjust the amplitude of the Quadrature signal. A power combiner receives the separately amplified In phase and Quadrature signals and sums and outputs the signals as a combined I and Q signal for further processing within the RF circuitry such that the I and Q signal inputs are isolated from the combined I and Q signal to enhance antenna matching and transmitted radiated power (TRP) and reduce harmonic emission from the power amplifier circuits.

The power combiner in one aspect is about a 3 dB power combiner and can be formed as a quadrature hybrid power combiner. It can be configured to reduce even order harmonics.

Each power amplifier circuit can be configured for about 30 dBm outputs as about 1 watt output power.

In yet another aspect, a local oscillator (LO) and frequency divider are operative with each of the modulator mixers within respective I and Q circuits. A bandpass filter can be connected between a respective modulator mixer and power amplifier circuit in each of the I and Q circuits. The RF circuitry can be operative for generating Global Systems for Mobile (GSM) packet bursts.

A method aspect is also set forth.

### Brief Description of the Drawings

Other objects, features and advantages will become apparent from the detailed description which follows, when considered in light of the accompanying drawings in which:
FIG. 1 is a schematic block diagram of an example of a mobile wireless communications device configured as a handheld device and illustrating basic internal components thereof as a non-limiting example.
FIG. 2 is a front elevation view of the mobile wireless communications device of FIG. 1.
FIG. 3 is a schematic block diagram showing basic functional circuit components that can be used in the mobile wireless communications device of FIGS. 1-2.
FIG. 4 is a fragmentary and isometric view of the rear or back section of a housing case as part of a housing for the mobile wireless communications device such as shown in FIGS. 1-3 and showing an example of the relative position of the antenna and battery charging contacts in a non-limiting example.
FIG. 5 is a fragmentary, side elevation view of a battery charging contact and its spring connector and antenna on the housing case and showing a filter positioned near the charging contacts to minimize transmission harmonics emission and receiver de-sense.
FIG. 6 is a block diagram of a conventional In-phase and Quadrature (I/Q) modulation and power amplification circuit showing one power amplification circuit after combining I/Q signals.
FIG. 7 is a block diagram of an In-phase and Quadrature modulation and power amplification circuit that includes a separate power amplifier circuit for each of the In-phase and Quadrature circuits in accordance with a non-limiting example.
FIGS. 8 and 9 are side elevation views of prior art antenna contacts used with different mobile wireless communications devices.
FIG. 10 is a schematic circuit diagram of the equivalent circuit for the prior art antenna contacts shown in FIGS. 8 and 9.
FIG. 11 is a fragmentary, isometric view of an antenna contact that, in accordance with a non-limiting example, ensures good radio frequency (RF) and mechanical performance.
FIG. 12 is another fragmentary, isometric view of the antenna contact as shown in FIG. 11 and showing the added conductive Electromagnetic Interference (EMI) material to reduce inductance and variation resulting from an extended RF stub.
FIG. 13 is a schematic circuit diagram of an equivalent RF circuit of the antenna contacts in accordance with a non-limiting example shown in FIGS. 11 and 12 that ensures good radio frequency (RF) and mechanical performance.
FIG. 14 is another fragmentary, isometric view of the antenna contact such as shown in FIG. 12 and showing a better view of the EMI material added near the contact point and also showing relative dimensions in a non-limiting example.

### Detailed Description of the Preferred Embodiments

The present description is made with reference to the accompanying drawings, in which preferred embodiments are shown. However, many different embodiments may be used, and thus the description should not be construed as limited to the embodiments set forth herein. Rather, these embodiments are provided so that this disclosure will be thorough and complete. Like numbers refer to like elements throughout.

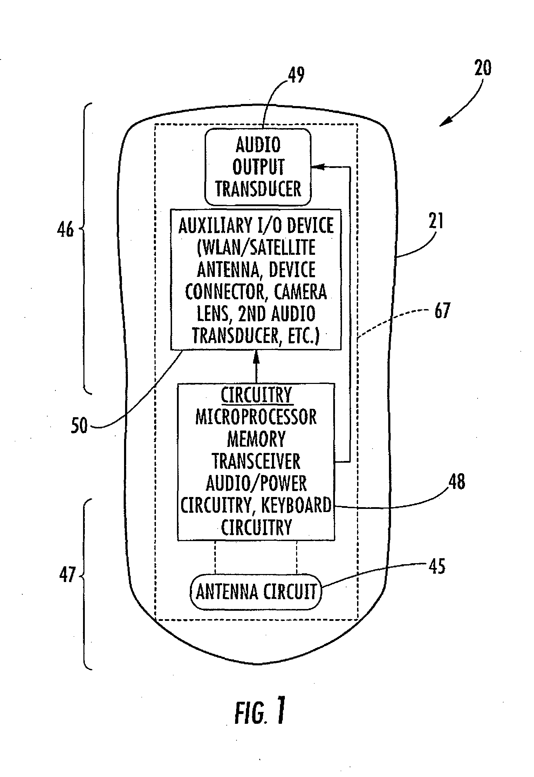

A brief description will now proceed relative to FIGS. 1-3, which discloses an example of a mobile wireless communications device, for example, a handheld portable cellular radio, which can incorporate non-limiting examples of the various circuits, including the improved battery charging contact circuit, In-phase and Quadrature Modulation and Power Amplification circuit, and antenna contact as later described. FIGS. 1-3 are representative non-limiting examples of the many different types of functional circuit components and their interconnection, and operative for use in the circuits of the mobile wireless communications device that can incorporate the improvements, advantages and features as described.

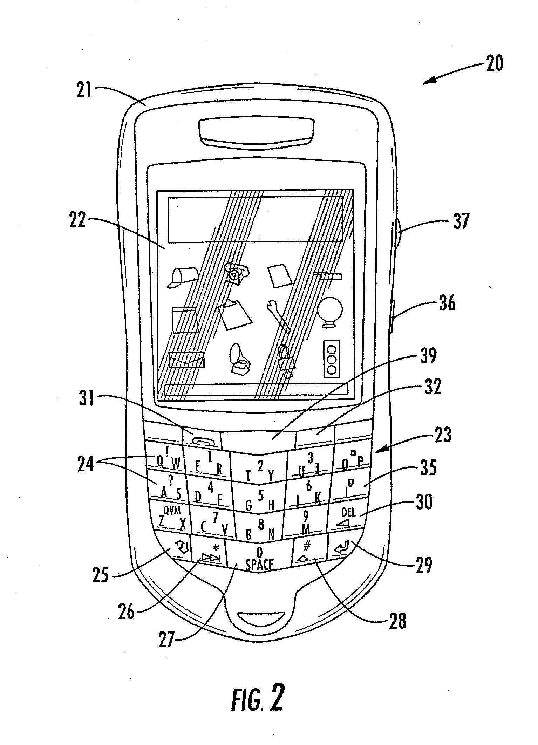

Referring initially to FIGS. 1 and 2, an example of a mobile wireless communications device **20**, such as a handheld portable cellular radio with improvements and advantages as described below is set forth. This device **20** illustratively includes a housing **21** having an upper portion **46** and a lower portion **47**, and at least one dielectric substrate (i.e., circuit board) **67**, such as a conventional printed circuit board (PCB) substrate, for example, carried by the housing. A number of different circuit boards can be used for supporting different components. For example, one circuit board could support the microprocessor and RF components, another circuit board could be formed as an antenna circuit board, and yet another circuit board could be formed as a circuit board for supporting different components such as a keyboard.

A housing (not shown in detail) would typically cover and enclose various components, such as circuit boards and an antenna. The housing includes a housing case, for example, a plastic case. The housing case could support a separate housing cover for front and rear sides depending on the type of design. Any type of housing or housing case will allow access to any circuit board and supports the one or more circuit boards. A battery opening provides access for a battery to power the device. The housing case could support an antenna in one non-limiting example, such as at its lower edge. The term circuit board **67** as used hereinafter can refer to any dielectric substrate, PCB, ceramic substrate or other circuit carrying structure for carrying signal circuits and electronic components within the mobile wireless communications device **20.** The illustrated housing **21** is a static housing, for example, but it should be understood that a flip or sliding housing can be used as is typical in many cellular and similar telephones. These and other housing configurations with different housing case designs may be used.

Circuitry **48** is carried by the circuit board **67,** such as a microprocessor, memory, one or more wireless transceivers (e.g., cellular, WLAN, etc.), which includes RF circuitry, including audio and power circuitry, and in this aspect, including any keyboard circuitry. This circuitry could also generally be termed RF circuitry. It should be understood that, as noted before, keyboard circuitry could be on a separate keyboard, etc., as will be appreciated by those skilled in the art. The different components as described can also be distributed on one circuit board or among a plurality of different circuit boards as noted before. A battery (not shown) is also preferably carried by the housing **21** for supplying power to the circuitry **48.** The term RF circuitry could encompass the interoperable RF transceiver circuitry, including receive and transmit circuits and power circuitry, including charging circuitry and audio circuitry, including In-phase and Quadrature circuits that include respective power amplifier circuits for respective In-phase and Quadrature circuits.

In one aspect, an audio output transducer **49** (e.g., a speaker) is carried by an upper portion **46** of the housing **21** and connected to the circuitry **48.** One or more user input interface devices, such as a keypad (keyboard) **23** (FIG. 2), is also preferably carried by the housing **21** and connected to the RF circuitry **48.** The term keypad as used herein also refers to the term keyboard, indicating the user input devices having lettered and/or numbered keys commonly known and other embodiments, including multi-top or predictive entry modes. Other examples of user input interface devices include a scroll wheel **37** and a back button **36.** Of course, it will be appreciated that other user input interface devices (e.g., a stylus or touch screen interface) may be used in other embodiments.

An antenna and associated antenna circuit **45** (FIG. 1) is preferably supported within the housing and in one aspect at a lower portion **47** in the housing, such as on the housing case lower edge. The antenna can be formed as a pattern of conductive traces that make an antenna circuit, which physically forms the antenna. It is operatively connected to the circuitry **48** on the main circuit board **67** or other circuitry on other boards. In one non-limiting example, the antenna could be formed on a separate antenna circuit board or an antenna circuit board section that extends from the main circuit board at the lower portion of the housing. By placing the antenna **45** adjacent the lower portion **47** of the housing 21, the distance is advantageously increased between the antenna and the user's head when the phone is in use to aid in complying with applicable SAR requirements. Also, a separate keyboard circuit board could be used as noted before.

More particularly, a user will typically hold the upper portion of the housing **21** very close to their head so that the audio output transducer **49** is directly next to the ear. Yet, the lower portion **47** of the housing **21** where an audio input transducer (i.e., microphone) is located need not be placed directly next to a user's mouth, and can be held away from the user's mouth. That is, holding the audio input transducer close to the user's mouth may not only be uncomfortable for the user, but it may also distort the user's voice in some circumstances.

In some designs, the antenna **45** is placed adjacent the lower portion **47** of the housing **21** to allow for less impact on antenna performance due to blockage by a user's hand. Users typically hold cellular phones towards the middle to upper portion of the phone housing, and are therefore more likely to put their hands over such an antenna than they are an antenna mounted adjacent the lower portion **47** of the housing **21.** Accordingly, more reliable performance may be achieved from placing the antenna **45** adjacent the lower portion **47** of the housing **21.**

Another benefit of this type of configuration is that it provides more room for one or more auxiliary input/output (I/O) devices **50** to be carried at the upper portion **46** of the housing. Furthermore, by separating the antenna **45** from the auxiliary I/O device(s) **50,** this may allow for reduced interference therebetween.

Some examples of auxiliary I/O devices **50** include a WLAN (e.g., Bluetooth, IEEE 802.11) antenna for providing WLAN communication capabilities, and/or a satellite positioning system (e.g., GPS, Galileo, etc.) antenna for providing position location capabilities, as will be appreciated by those skilled in the art. Other examples of auxiliary I/O devices 50 include a second audio output transducer (e.g., a speaker for speaker phone operation), and a camera lens for providing digital camera capabilities, an electrical device connector (e.g., USB, headphone, secure digital (SD) or memory card, etc.).

It should be noted that the term "input/output" as used herein for the auxiliary I/O device(s) 50 means that such devices may have input and/or output capabilities, and they need not provide both in all embodiments. That is, devices such as camera lenses may only receive an optical input, for example, while a headphone jack may only provide an audio output.

The device **20** further illustratively includes a display **22,** for example, a liquid crystal display (LCD) carried by the housing **21** and connected to the circuitry **48.** A back button **36** and scroll wheel **37** can also be connected to the circuitry **48** for allowing a user to navigate menus, text, etc., as will be appreciated by those skilled in the art. The scroll wheel **37** may also be referred to as a "thumb wheel" or a "track wheel" in some instances. The keypad **23** illustratively includes a plurality of multi-symbol keys **24** each having indicia of a plurality of respective symbols thereon. The keypad **23** also illustratively includes an alternate function key **25,** a next key **26,** a space key **27,** a shift key **28,** a return (or enter) key **29,** and a backspace/delete key **30.**

The next key **26** is also used to enter a "*" symbol upon first pressing or actuating the alternate function key **25.** Similarly, the space key **27,** shift key **28** and backspace key **30** are used to enter a "0" and "#", respectively, upon first actuating the alternate function key **25.** The keypad **23** further illustratively includes a send key **31,** an end key **32,** and a convenience (i.e., menu) key **39** for use in placing cellular telephone calls, as will be appreciated by those skilled in the art.

Moreover, the symbols on each key **24** are arranged in top and bottom rows. The symbols in the bottom rows are entered when a user presses a key **24** without first pressing the alternate function key **25,** while the top row symbols are entered by first pressing the alternate function key. As seen in FIG. 2, the multi-symbol keys **24** are arranged in the first three rows on the keypad **23** below the send and end keys **31, 32.** Furthermore, the letter symbols on each of the keys **24** are arranged to define a QWERTY layout. The letters on the keypad **23** are presented in a three-row format, with the letters of each row being in the same order and relative position as in a standard QWERTY keypad.

Each row of keys (including the fourth row of function keys **25-29)** is arranged in five columns in this non-limiting example. The multi-symbol keys **24** in the second, third, and fourth columns of the first, second, and third rows have numeric indicia thereon (i.e., 1 through 9) accessible by first actuating the alternate function key **25.** Coupled with the next, space, and shift keys **26, 27, 28,** which respectively enter a "*", "0", and "#" upon first actuating the alternate function key **25,** as noted above, this set of keys defines a standard telephone keypad layout, as would be found on a traditional touch-tone telephone, as will be appreciated by those skilled in the art.

Accordingly, the mobile wireless communications device **20** as described may advantageously be used not only as a traditional cellular phone, but it may also be conveniently used for sending and/or receiving data over a cellular or other network, such as Internet and email data, for example. Of course, other keypad configurations may also be used in other embodiments. Multi-tap or predictive entry modes may be used for typing e-mails, etc. as will be appreciated by those skilled in the art.

In one non-limiting aspect, the antenna **45** is preferably formed as a multi-frequency band antenna, which provides enhanced transmission and reception characteristics over multiple operating frequencies. More particularly, the antenna **45** is designed to provide high gain, desired impedance matching, and meet applicable SAR requirements over a relatively wide bandwidth and multiple cellular frequency bands. By way of example, in one non-limiting example, the antenna **45** preferably operates over five bands, namely a 850 MHz Global System for Mobile Communications (GSM) band, a 900 MHz GSM band, a DCS band, a PCS band, and a WCDMA band (i.e., up to about 2100 MHz), although it may be used for other bands/frequencies as well. To conserve space, the antenna **45** may advantageously be implemented in three dimensions although it may be implemented in two-dimensional or planar embodiments as well. In one non-limiting example, it is L-configured and positioned at the lower portion or edge of the support case.

The mobile wireless communications device shown in FIGS. 1 and 2 can incorporate email and messaging accounts and provide different functions such as composing e-mail, PIN messages, and SMS messages. The device can manage messages through an appropriate menu that can be retrieved by choosing a messages icon. An address book function could add contacts, allow management of an address book, set address book options and manage SIM card phone books. A phone menu could allow for the making and answering of phone calls using different phone features, managing phone call logs, setting phone options, and viewing phone information. A browser application could permit the browsing of web pages, configuring a browser, adding bookmarks, and changing browser options. Other applications could include a task, memo pad, calculator, alarm and games, as well as handheld options with various references.

A calendar icon can be chosen for entering a calendar program that can be used for establishing and managing events such as meetings or appointments. The calendar program could be any type of messaging or appointment/meeting program that allows an organizer to establish an event, for example, an appointment or meeting.

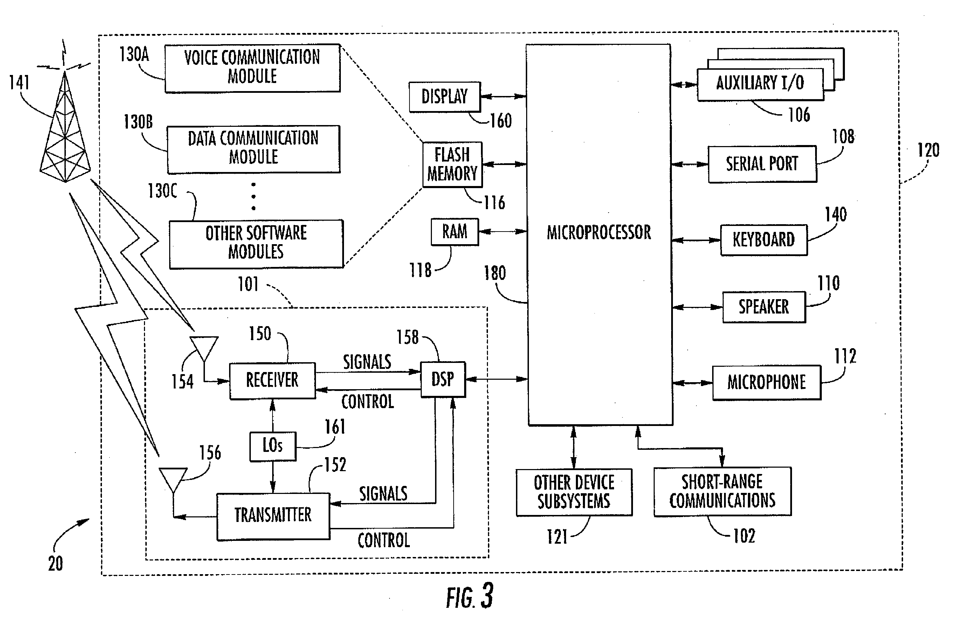

A non-limiting example of various functional components that can be used in the exemplary mobile wireless communications device **20** of FIGS. 1 and 2 is further described in the example below with reference to FIG. 3. The device **20** illustratively includes a housing **120** shown in outline by the dashed lines, a keypad **140,** and an output device **160.** The output device **160** shown is preferably a display, which is preferably a full graphic LCD. Other types of output devices may alternatively be used. A processing device **180** such as a microprocessor is contained within the housing **120** and is coupled between the keypad **140** and the display **160.** The processing device **180** controls the operation of the display **160,** as well as the overall operation of the mobile device **20,** in response to actuation of keys on the keypad **140** by the user.

The housing **120** may be elongated vertically, or may take on other sizes and shapes (including clamshell housing structures). The keypad may include a mode selection key, or other hardware or software for switching between text entry and telephony entry.

In addition to the processing device **180,** other parts of the mobile device **20** are shown schematically in FIG. 3. These include a communications subsystem **101;** a short-range communications subsystem **102;** the keypad **140** and the display **160,** along with other input/output devices **106, 108, 110** and **112;** as well as memory devices **116, 118** and various other device subsystems **121.** The mobile device **20** is preferably a two-way RF communications device having voice and data communications capabilities. In addition, the mobile device **20** preferably has the capability to communicate with other computer systems via the Internet.

Operating system software executed by the processing device **180** is preferably stored in a persistent store, such as the flash memory **116,** but may be stored in other types of memory devices, such as a read only memory (ROM) or similar storage element. In addition, system software, specific device applications, or parts thereof, may be temporarily loaded into a volatile store, such as the random access memory (RAM) **118.** Communications signals received by the mobile device may also be stored in the RAM **118.**

The processing device **180,** in addition to its operating system functions, enables execution of software applications **130A-130N** on the device **20.** A predetermined set of applications that control basic device operations, such as data and voice communications **130A** and **130B,** may be installed on the device **20** during manufacture. In addition, a personal information manager (PIM) application may be installed during manufacture. The PIM is preferably capable of organizing and managing data items, such as e-mail, calendar events, voice mails, appointments, and task items. The PIM application is also preferably capable of sending and receiving data items via a wireless network **141.** Preferably, the PIM data items are seamlessly integrated, synchronized and updated via the wireless network **141** with the device user's corresponding data items stored or associated with a host computer system.

Communication functions, including data and voice communications, are performed through the communications subsystem **101,** and possibly through the short-range communications subsystem. The communications subsystem **101** includes a receiver **150,** a transmitter **152,** and one or more antennae **154** and **156.** In addition, the communications subsystem **101** also includes a processing module, such as a digital signal processor (DSP) **158,** and local oscillators (LOs) **161.** The specific design and implementation of the communications subsystem **101** is dependent upon the communications network in which the mobile device **20** is intended to operate. For example, the mobile device **20** may include a communications subsystem **101** designed to operate with the Mobitex^{™}, Data TAC^{™} or General Packet Radio Service (GPRS) mobile data communications networks, and also designed to operate with any of a variety of voice communications networks, such as AMPS, TDMA, CDMA, PCS, GSM, etc. Other types of data and voice networks, both separate and integrated, may also be utilized with the mobile device **20.**

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore requires a subscriber identity module, commonly referred to as a SIM card, in order to operate on a GPRS network.

When required network registration or activation procedures have been completed, the mobile device **20** may send and receive communications signals over the communication network **141.** Signals received from the communications network **141** by the antenna **154** are routed to the receiver **150,** which provides for signal amplification, frequency down conversion, filtering, channel selection, etc., and may also provide analog to digital conversion. Analog-to-digital conversion of the received signal allows the DSP **158** to perform more complex communications functions, such as demodulation and decoding. In a similar manner, signals to be transmitted to the network **141** are processed (e.g., modulated and encoded) by the DSP **158** and are then provided to the transmitter **152** for digital to analog conversion, frequency up conversion, filtering, amplification and transmission to the communication network **141** (or networks) via the antenna **156.**

In addition to processing communications signals, the DSP **158** provides for control of the receiver **150** and the transmitter **152.** For example, gains applied to communications signals in the receiver **150** and transmitter **152** may be adaptively controlled through automatic gain control algorithms implemented in the DSP **158.**

In a data communications mode, a received signal, such as a text message or web page download, is processed by the communications subsystem **101** and is input to the processing device **180.** The received signal is then further processed by the processing device **180** for an output to the display **160,** or alternatively to some other auxiliary I/O device **106.** A device user may also compose data items, such as e-mail messages, using the keypad **140** and/or some other auxiliary I/O device **106,** such as a touchpad, a rocker switch, a thumb-wheel, or some other type of input device. The composed data items may then be transmitted over the communications network **141** via the communications subsystem 101.

In a voice communications mode, overall operation of the device is substantially similar to the data communications mode, except that received signals are output to a speaker **110,** and signals for transmission are generated by a microphone **112.** Alternative voice or audio I/O subsystems, such as a voice message recording subsystem, may also be implemented on the device **20.** In addition, the display **160** may also be utilized in voice communications mode, for example to display the identity of a calling party, the duration of a voice call, or other voice call related information.

Any short-range communications subsystem enables communication between the mobile device **20** and other proximate systems or devices, which need not necessarily be similar devices. For example, the short-range communications subsystem may include an infrared device and associated circuits and components, or a Bluetooth^{™} communications module to provide for communication with similarly-enabled systems and devices.

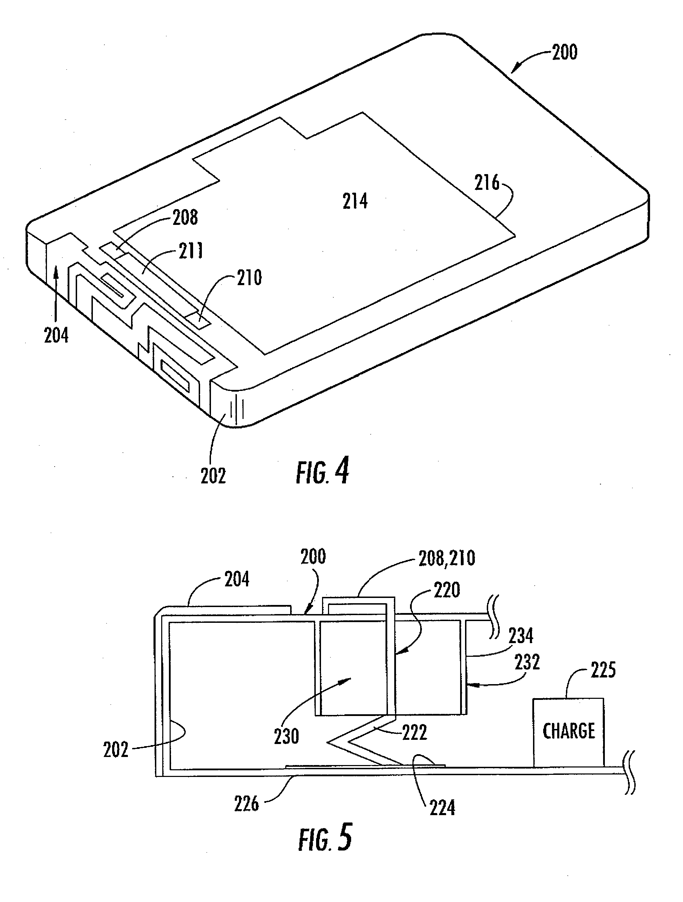

FIG. 4 shows a section of the mobile wireless communications device such as shown in FIGS. 1-3 and showing the relative position of the antenna and battery charging contacts on a portion of the back or rear section of the housing case **200** as part of the housing forming the mobile wireless communications device. A rear cover in some non-limiting examples could be inserted over the illustrated housing case. It is shown removed in this non-limiting example. In other aspects, the housing case could include integrated or separate front and rear housing covers depending on specific design options.

As illustrated in this one particular configuration, the housing case **200** is substantially rectangular configured and includes opposing ends and longitudinal edges and includes an end formed as a lower edge **202** corresponding, for example, to the lower portion **47** of the mobile wireless communications device of FIG. 1. The antenna **204** in this example is supported at the lower edge **202** of the housing case **200** and configured as an L-shaped antenna in cross-section and extends over the lower edge **202** of the housing case as illustrated. In this example, the antenna **204** extends substantially along the entire lower edge **202** except at the longitudinal edges.

Two battery charging contacts **208, 210** are positioned on the housing case **200** and operable to engage charging contacts (not shown) such as part of a charging cradle. The charging contacts **208, 210** are separated by an insulator strip **211** in this example. The battery charging contacts **208, 210** are placed in close proximity to the antenna **204** as illustrated in FIG. 4. On the housing case **200,** the central section is defined by a battery well **214** to which a battery for powering the device could be received, and shown by the rectangular line **216** and could also define an area in the housing case **200** for access to various components, including any PCB boards as described relative to FIGS. 1-3.

Charging contacts are a feature of many mobile wireless communications devices such as shown and described relative to FIGS. 1-3. As shown by the close proximity between the battery charging contacts **208, 210** and the antenna **204** in FIG. 4, radio frequency (RF) coupling occurs at the charging contacts and can affect the antenna performance and cause transmitter circuitry harmonics emissions and receiver circuitry de-sense. The charging contacts **208, 210** are typically also positioned close to a power amplifier circuit such as described relative to FIGS. 1-3, which also causes various RF and other interference issues with the internal circuitry and antenna.

As shown in FIG. 5, each of the charging contacts **208, 210** includes an internal connector as an electrical conductor indicated generally at **220** that extends downward and includes a lower internal spring (e.g., biased) connector **222** that connects to a battery charging pad **224** positioned on the printed circuit board **226.** Thus, each internal connector **220** with its associated spring connector **222** segment forms a biased electrical connector between the exposed surface of the contact such as shown by the reference numerals **208** and **210** in FIG. 4 and battery charging pads on the circuit board. In this side elevation view, only one charging contact and associated battery charging pad is illustrated. The battery charging pad **224** connects to battery charging circuitry **225** such as by signal traces on the circuit board. The charging circuitry **225** could be separate from the circuit board in some examples and connected by lead wires to battery charging pad **224.** It should be understood that in this example, FIG. 5 shows only one charging contact in this elevation view, but each charging contact could have an internal connector **220** and its associated lower section formed as a spring connector **222** connected to a respective battery charging pad **224.**

The battery charging contacts **208, 210,** and any associated battery charging pad **224** and the internal connector **220** and its associated spring connector **222** can operate similar to an antenna, creating some interference issues. The charging contacts **208, 210,** their internal connector **220** and associated spring connector **222** and the battery charging pad **224** connect to the charging circuit **225,** which typically has a low impedance for RF. It is typically close to the antenna, and heavily couples energy to the antenna **204** and loads the antenna impedance. A respective charging contact could have a respective polarity as understood by those skilled in the art.

Any type of spring connector such as the illustrated internal connector **220** with its associated spring connector **222** can resonate at the band of interest and cause interference. The battery charging contacts **208, 210** with their internal connectors and charging pads can pick up digital noise from the digital circuits as part of a mobile wireless communications device where energy is supplied from the battery and coupled back with any power amplifier harmonics to the battery and battery charging circuit. This creates even greater digital noise and desensitizes any radio frequency circuitry associated with the receiver. Also, during any transmission, a power amplifier can eject harmonics and these harmonics can be coupled to the charging contacts **208, 210.**

Some proposals to reduce interference have used ferrite beads positioned on printed circuit boards, for example, on the signal traces formed on circuit boards, to reduce the harmonics and interference. Ferrite beads on a circuit board help reduce noise coupled beyond the ferrite beads, for example, close to any internal connectors including spring connectors, charging contacts or battery charging pads. The ferrite beads, however, are positioned on the circuit board and not at the internal connectors and associated spring connectors and charging contacts for the charging circuit. Thus, the RF impedance is still increased at that point in some designs.

As shown in FIG. 5, an RF filter **230** as a core of ferrite material is placed at each of the respective charging contacts **208, 210** at a portion of the internal connector **220** above the associated spring connector **222** in this non-limiting example and will prevent RF coupling to the antenna **202** and the associated battery charging contact and its internal connector and associated spring connector **222** and any associated battery charging pads. This ferrite material will also prevent high impedance and prevent noise from being ejected that will de-sense the receiver circuit or radiate harmonics during the transmit mode.

The L-shaped antenna **204** as shown in FIG. 4 in this example is wrapped around the lower edge **202** of the support case **200** (FIG. 5). The PCB board **226** as illustrated includes the various RF components as described relative to FIGS. 1-3, including connection lines and other components. These components are not shown in detail in FIG. 5. The battery charging contacts **208, 210** are shown closely positioned near the antenna **204** and supported by the housing case **200** and, as explained before, include the downward extending internal connector **220** and its associated lower section formed as a spring connector **222** and such that battery charging contacts **208, 210** electrically engage a battery charging pad **224** on the printed circuit board **226** as part of the battery charging circuit. As illustrated, the battery charging pad **224** connects to part of charging circuit **225,** which is positioned on the circuit board in this non-limiting example, but as noted before, could be supported elsewhere in the housing.

As illustrated, an internal section of the housing corresponding to the housing case **200** includes a downward extending RF filter support **232** for the ferrite material as an RF filter **230,** e.g., a "holster," as a non-limiting example in this instance, which could be formed as a cylindrical wall **234** that extends around a substantial portion of the internal connector to hold the ferrite material (formed cylindrically in this example to fit within the filter support) in place relative to the battery charging contacts and their internal connector **220** up to the lower spring connector **222.** The RF filter **230** formed from the ferrite material does not interfere with the biasing action of the internal connector in this non-limiting example since the spring connector is not covered. Other configurations besides a cylinder could be used to form the RF filter support **232** as part of the housing case. The ferrite material **230** is received in this RF filter support and secured thereby and acts similar to a ferrite bead relative to the internal connector **220** and its associated spring connector **222** as part of the battery charging contact **208** and prevents RF coupling. The ferrite material as an RF filter **230** acts similar to a ferrite bead, such as placed directly on the circuit board, but instead is a ferrite material that encompasses a portion of the internal connector **220.** It could also encompass part of the associated spring connector **222** as long as it did not interfere with any biasing function of the spring connector.

In this non-limiting example, the spring connector **222** as part of the internal connector **220** is used to add resilience to the overall connector. The mobile wireless communications device during charging is typically placed in a charging cradle (in this example), and resilience in movement helps ensure contact for charging. The ferrite based RF filter **230** is incorporated with the charging contacts **208, 210** and provides the high RF impedance across the frequency bands of interest such that the charging contacts will present high impedance to the antenna. Therefore, the antenna performance will not be degraded.

This RF filter **230** is formed in this non-limiting example from a ferrite material that blocks the transmission (Tx) harmonics coupled from any RF power amplifier to any traces or connection lines formed on the printed circuit board such as from the battery charging pad and prevent any energy from radiating by the charging contacts. In a radio frequency (RF) receive mode, most of the digital noise coupled from the processor or other CPU and other high frequency digital circuits to the charging contacts **208, 210** will be eliminated by the ferrite RF filter **230,** which prevents receiver de-sensing due to the noise picked-up by the antenna **204.** By implementing this RF filter **230** near the charging contacts **208, 210** as shown in FIG. 5, these technical problems are minimized as compared to a more conventional technique of placing ferrite beads on a printed circuit board. Thus, the charging contacts **208, 210** are designed such as in the non-limiting example shown in FIG. 5 to incorporate the RF filter **230.**

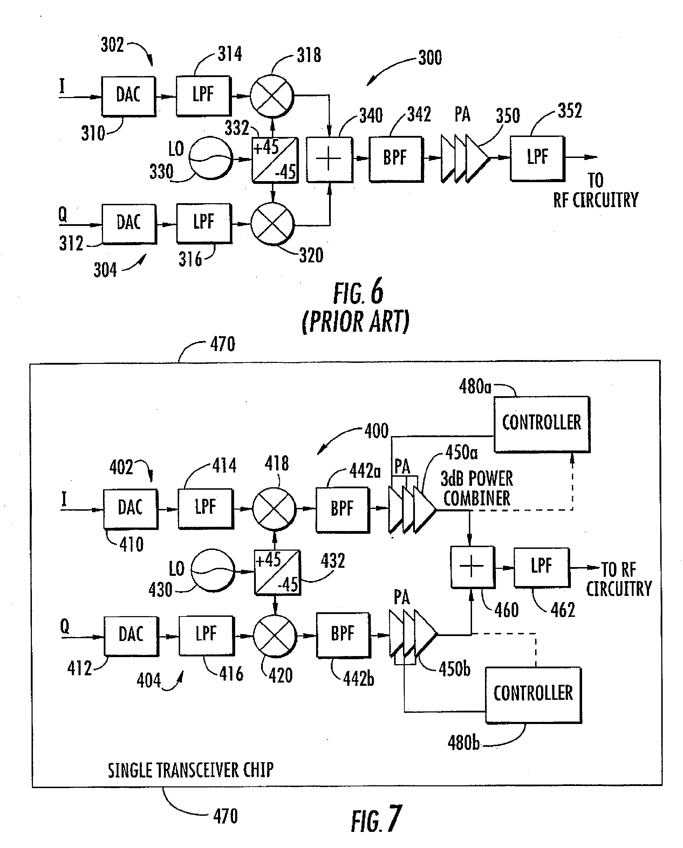

Referring now to FIG. 6, there is illustrated a block diagram of a conventional In-phase and Quadrature (I/Q) modulation and power amplification circuit illustrated generally at **300** that is typically used in many different types of communications devices, especially lower power mobile wireless communications devices. The circuit **300** has one power amplifier circuit after the In-phase and Quadrature modulation and mixing and power combining.

FIG. 6 shows this conventional I/Q modulation and power amplification circuit **300.** It has In-phase and Quadrature inputs (I) and (Q) for a respective In-phase circuit **302** and Quadrature circuit **304** that each include a respective digital-to-analog converter (DAC) **310, 312,** low pass filter **314, 316** and mixer **318, 320** as illustrated. A local oscillator **330** generates a local oscillator (LO) signal into a frequency divider **332,** which passes the resulting and divided signals into the respective mixers **318, 320** as illustrated. The frequency divider **332** provides for +45 and -45 phase/frequency adjustment for I and Q modulation.

The output from the mixers **318, 320** are combined (or summed) at a power combiner **340** into one signal that is then bandpass filtered within a respective bandpass filter **342.** One or more RF power amplifiers form a power amplifier circuit **350** amplifies the signal after bandpass filtering. The amplified signal is then filtered in a low pass filter **352.** The filtered signal is passed to further RF circuits for other processing, including an antenna as part of any transmitter circuitry for signal transmission over-the-air. The modulation and power amplification circuit **300** shown in FIG. 6 may have linearity issues with the power amplifier (PA) circuit **350** and requires a more flexible IQ modulation scheme. This can be especially relevant when the power amplifier circuit design is used for 8 PSK (phase shift keying), quadrature amplitude modulation (QAM) and similar modulation schemes, typical in some lower power communications devices.

This conventional circuit **300** also may have a poor antenna match degrading total radiated power (TRP) and cause less efficiency because of the current power amplifier drawbacks, making it difficult to make improvements in radio frequency transmitter performance and battery life. Also, this type of conventional circuit **300** may have harmonics issues because of the higher non-linearity of the power amplifier. Some very high power I/Q modulation circuits such as in large and powerful base stations may use multiple power amplifiers that are power combined into an antenna, but they typically incorporate complex circuit features such as feed forward, feedback, free-distortion, complex mixing and complex power amplifier circuits. Those types of solutions are not always adequate for lower power mobile wireless communications device. Some communications circuits for I/Q modulation incorporate parallel output stages. These are usually targeted to achieve better linearity in any power amplifier circuit. The parallel output stages are sometimes used for heat control, increased power output, signal quality, peak power improvement and similar aspects. These circuits still may suffer drawbacks and may not be as reliable or adapted for lower power application as indicated above.

FIG. 7 is a block diagram of an IQ modulation and power amplification circuit **400** in accordance with a non-limiting aspect that includes I/Q signal inputs and an In-phase circuit **402** and Quadrature circuit **404,** including the basic components in each I/Q circuit **402, 404** of a respective DAC **410, 412,** LPF **414, 416** and mixer **418, 420.** The components are similar to components shown in FIG. 6, but with modifications that could be made as a result of the changes in each I/Q circuit **402, 404** to include a power amplifier circuit as described below.

Each I/Q circuit **402, 404** includes a power amplifier circuit **450a, 450b** that is used only for amplifying respective I or Q signals in the respective I/Q circuits **402, 404.** The respective power amplifier circuit **450a, 450b** is positioned into each of the respective In-phase and Quadrature circuits **402, 404.** The local oscillator **430** and frequency divider circuits **432** can be similar as with the circuit of FIG. 6 with modifications as are necessary. After mixing within respective mixers **418, 420,** the respective I and Q signals are each bandpass filtered within the respective bandpass filters **442a, 442b,** and then each power amplified by respective power amplifier circuits **450a, 450b** such that the separate In-phase and Quadrature signals are power amplified separately and not after being combined as in the circuit of FIG. 6. Afterward, the respective I and Q signals are power combined within a power combiner **460** and the resultant signal filtered within a low pass filter **462.**

This I/Q modulation and power amplification circuit **400** in this non-limiting example uses two separate power amplifier circuits **450a, 450b** with 3 dB less output power as compared to a more conventional single power amplifier circuit positioned after combining such as shown in FIG. 6, resulting in better linearity of the power amplifier circuit and increased DC power efficiency, while still maintaining the same output power through a 3 dB power combiner **460** as a non-limiting example. The power combiner **460** isolates the output from the input such that the circuit **400** can prevent a poor antenna match from directly affecting the power amplifier and radio frequency (RF) performance. With higher and more efficient power amplifier circuits **450a, 450b** as described for each I/Q circuit **402, 404,** it is possible to gain longer battery life. Because it is possible to use more linear power amplifiers with the design as shown in FIG. 7, there is less harmonic emission from the power amplifier output.

Not only is IQ modulation achieved with the circuit design shown in FIG. 7, but also digital amplitude, frequency and phase modulation is achieved in an efficient manner. The better linearity and power-added efficiency occurs because of using smaller power amplifier circuits such as associated with a mobile wireless communications device to achieve a desired output power, for example, greater than 33 dBm. This I/Q modulation and power amplification circuit **400** allows a more flexible digital modulation for different modulation schemes with similar hardware architectures. It is possible to implement the circuit **400** on a single transceiver chip such as shown by the line at **470** due to the use of the respective power amplifier circuits **450a, 450b,** transmitting 3 dB less of RF power than a normal single power amplifier circuit **350** such as shown in FIG. 6. The IQ modulation and power amplification circuit **400** shown in FIG. 7 includes as a non-limiting example a 3 dB power combiner **460** such as a quadrature hybrid power combiner and provides an easier power amplifier match for better output power, efficiency and immunity to mobile antenna impedance change. The power combiner **460** also allows the cancellation of even order transmit harmonics, which in turn, will make any harmonics filter design easier with less insertion loss and associated factors.

A quadrature hybrid power combiner **460** as a non-limiting example can be formed using different techniques and typically combines two, usually equal amplitude, quadrature-phased input signals into a single output signal. The combiner could use lumped element circuits, strip line circuits, or other circuits. The strip line circuits can be used in those applications requiring low loss or high power or both. Typically, a fundamental circuit element is a 3 dB quarter-wave coupler and formed as a four port network. The signal applied to a first port could be split equally between a second and third port with one of the outputs having a relative 90-degree phase shift. When the second and third ports are terminated into matching impedances, the signal applied to the first port is typically transmitted to a load connected to the second and third ports such that a fourth port receives negligible power and is "isolated." An impedance mismatch at the second port could reflect some signal power back from the second port to be divided proportionally between the first and fourth ports. It is also possible to vary the relative input/output phasing even though the relationship between the output ports is maintained at 90 degrees. It may be possible to form a lumped element construction with one or more toroidal cores. Typically in a lumped element design, the insertion loss is related to the Q values of different components used in the network. In a strip line component, however, the insertion loss can result from the resistance of conductors and a mismatch loss at input/output ports and directivity loss. Thicker conductors could reduce some of that loss.

The I/Q modulation and power amplification circuit **400** shown in FIG. 7 overcomes the technical drawbacks and problems associated with the type of circuit **300** shown in FIG. 6 in which only one power amplifier circuit **350** is used after power combining, especially with power amplifier designs for GSM/GPRS/EDGE systems to achieve both GMSK and 8 PSK. Different RF transceiver systems have different transceiver architectures for digital frequency and phase modulations with IQ modulation.

The I/Q modulation and power amplification circuit **400** of FIG. 7 with respective power amplifier circuits **450a, 450b** in each of I and Q circuits **402, 404** allows greater control over any power amplifier driver and/or power amplifier biasing, even when using either open loop systems or larger or smaller closed loop systems. Controllers **480a, 480b** (or one controller) are operative with the respective power amplifier circuit **450a, 450b** and controls gain and other factors. The controllers **480a, 480b** can be open loop or closed loop control (as shown by the dashed feedback line in each circuit). The I/Q modulation and power amplification circuit **400** shown in FIG. 7 unifies the IQ modulation scheme with linear/higher efficiency/higher power requirements of power amplifier designs such that different types of digital modulations, for example, AM, FM and PM can be fulfilled. Also, the two respective power amplifier circuits **450a, 450b** shown in FIG. 7 can be calibrated to achieve high linear/efficiency/power amplifier design with low harmonics and less sensitivity to antenna loading.

In one non-limiting aspect, the power combiner **460** is operative as a 3 dB quadrature hybrid combiner as noted before. With this circuit design as described, two power amplifier circuits **450a, 450b** could be used with only 30 dBm (1 watt) output power to achieve 33 dBm. The loss due to the power combiner **460** could be about 0.2 to about 0.3 dB, which could handled using a sharp low pass filter **462** to force down the third harmonics of the power amplifier. Thus, it is possible that the power amplifier circuits **450a, 450b** with 30 dBm output can be established to achieve 33 dBm output. Typically, using the 3 dB quadrature hybrid power combiner **460,** it is possible to isolate the antenna matching from the power amplifier matching to obtain better transmission radiated power (TRP). As a result, the antenna design does not require more than one feed port to incorporate the power combiner as described.

It should be understood that the quadrature hybrid power combiner **460** can be tolerable to the mismatch of an antenna load impedance. Also, the quadrature hybrid gives greater reflectivity for phase and frequency modulation. Thus, efficient amplitude modulation can occur by changing the bias of the power amplifier circuits **450a, 450b** for each of the In-phase and Quadrature circuits **402,404** and give greater flexibility in circuit function.

FIG. 7A illustrates a graph showing an example of the cancellation of some even order harmonics using the circuit of FIG. 7.

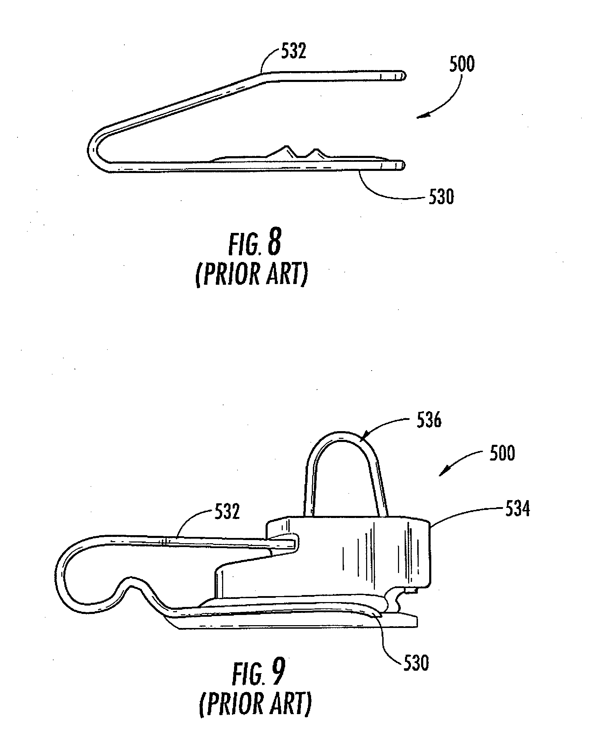

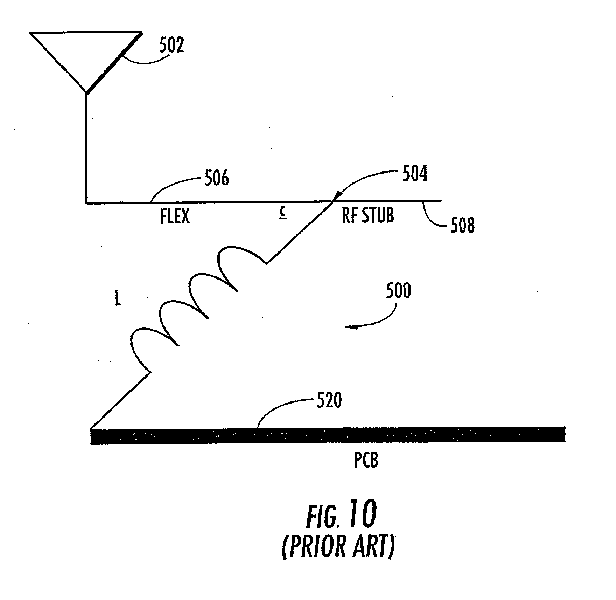

Some mobile wireless communications devices incorporate various antenna designs that include antenna contacts such as shown in FIGS. 8 and 9. These antenna contacts typically connect between an antenna carried inside the mobile wireless communications device such as shown in FIGS. 1-3 and a circuit board carrying RF circuitry, such as a transceiver. An equivalent schematic circuit diagram for the antenna contact **500** of FIGS. 8 and 9 and an associated antenna is shown in FIG. 10 in which the antenna **502** is illustrated. This antenna **502** includes a contact point (c) **504** connecting the antenna contact and at an antenna flex section **506** that extends from the contact point (c) **504** to the point where the antenna contact connects, and an extended flex section as an RF stub **508.**

As illustrated, the antenna contact **500** is configured to act like a spring such as shown in the examples of FIGS. 9 and 10 (configured similar to an elongated clip or hairpin with upper and lower or top and bottom legs) and having an inductance L, based on its configuration and its contact to the RF stub and flex and to a contact on the printed circuit board **520.** Both FIGS. 9 and 10 show how the antenna contact **500** forms a spring type mechanism in which the lower section or leg **530** forms a board contact that could be soldered or attached by other techniques to the printed circuit board **520,** for example, an antenna board as in FIG. 10. The upper section or leg **532** of the antenna contact is a biased spring section forming an upper leg engages an antenna at its contact point **504,** including any necessary feed lines or other contact points or connections.

FIG. 9 shows an additional contact section **534** that slides on the upper spring biased section or leg **532** to form a section that engages at the contact point the RF stub as explained before. This contact section **534** includes an upper contact member **536** shaped in an inverted U for making contact to the antenna near the RF stub at the contact point in one non-limiting example. The antenna contact **500** in FIG. 8 could have a similar additional upper contact member **534** slid thereon.

One drawback of such antenna contact designs as shown in FIGS. 8 and 9 and the equivalent schematic circuit of FIG. 10 is that these antenna contacts as circuits do not provide adequate RF performance because of the long physical length that creates a higher radio frequency (RF) inductance. The RF performance varies significantly because of the design variation in antenna contact design. Also, the spring effect of these types of antenna contacts often is lost after being depressed even one time. This type of antenna contact is not as strong as desirable and does not adequately secure to an antenna after the mobile wireless communications device has been dropped several times, thus, creating reliability issues such as caused from weak solder joints engaging the antenna contact, for example, to the circuit board.

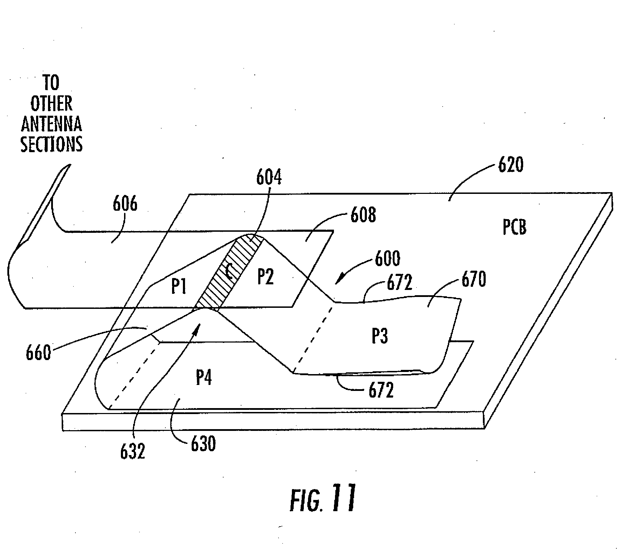

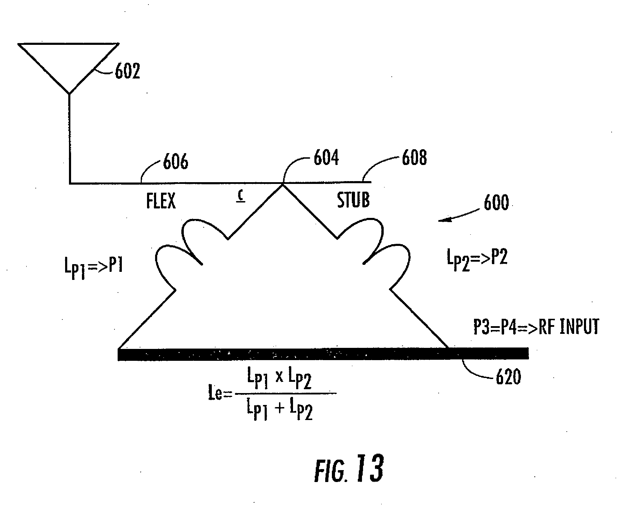

FIGS. 11-14 show an antenna contact **600** in accordance with a non-limiting aspect that offers better RF performance by significantly reducing any antenna contact length and providing parallel inductances as shown in the equivalent schematic circuit diagram of FIG. 13. This antenna contact **600** has similar functional components as in that shown in FIGS. 8-10 but with enhanced performance resulting from better design. As shown in the schematic circuit diagram of FIG. 13, basic components of the antenna contact **600** include the extended flex portion as the RF stub **608,** the contact point **604,** the antenna flex **606** and other portions forming the antenna **602** and operating through RF components on the circuit board **620** such as a transceiver circuit. The equivalent inductance Le in FIG. 13 is significantly reduced as compared with the single higher inductance of L shown in the antenna contact and associated antenna schematic circuit of FIG. 8.

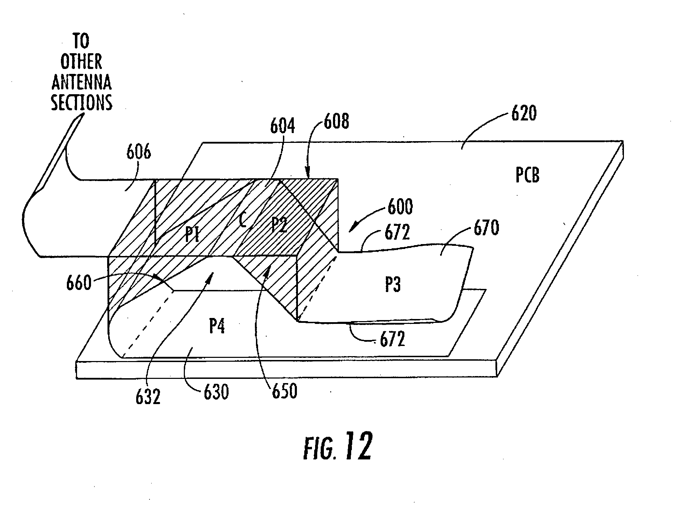

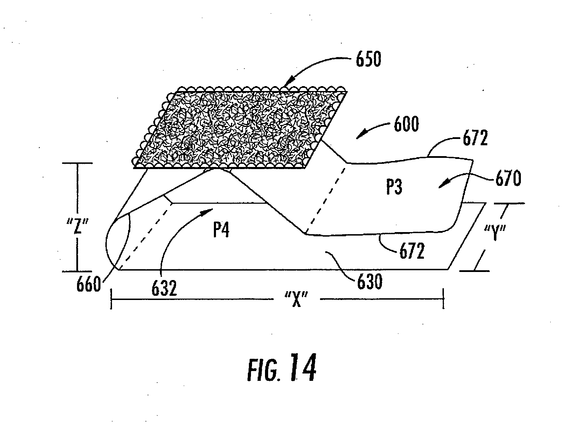

FIGS. 11, 12 and 14 are fragmentary and partial isometric views of the antenna contact **600** and showing the basic configuration in FIG. 12 with a portion of the antenna flex 606 and the contact point **604** and RF stub **608.** Relative dimensions are shown in the equivalent schematic circuit of FIGS. 13 and 14 to give an idea of the resulting improvement in performance.

This configuration as shown in FIGS. 11-14 provides consistent physical contact with the antenna flex **606** and RF stub **608** (FIG. 11). To reduce the variation of the contact point C **604** and the extended antenna flex **606** and the RF stub **608,** a core shield EMI material **650** as an RF filter is added on the antenna flex at the contact point and engages the RF stub **608** and provides secure contact and low RF inductance and variation. As illustrated, to strengthen the resulting biasing of the antenna contact configuration, the antenna contact **600** includes a lower leg **630** at the upper spring biased section or upper leg **632** is formed to have increased mechanical support resulting from an inverted V-shaped configuration forming P1 and P2 for that upper section or upper leg **632** along with a horizontally extending slide landing element **670** P3. To avoid potential solder wicking during a solder reflow process when the antenna contact **600** is soldered onto a circuit board such as a main circuit board or antenna board, the edges **672** for the slide landing element P3 **670** are elevated from contact with P4 **630** as the lower section that contacts the printed circuit board and forms a concave shape or U-shaped bend while still maintaining physical and electrical contact with the lower leg **630** P4. Thus, the antenna contact still has a configuration similar to a C-clip, but with greater efficiency of design. This improved antenna contact **600** as described and shown in FIGS. 11-13 provides strong and secure physical contact to improve the reliability of a drop test while offering good and consistent radio frequency (RF) performance.

The EMI material forming the filter **650** as shown in FIGS. 12 and 14 can be a conductive foam glued to the antenna flex as the RF stub **608,** such as a gore-shield^{R} EMI material as the GS8000 EMI shielding gasket. This type of material provides excellent conformability and excellent cavity-to-cavity EMI shielding and conductivity at low compressive forces.

This type of material can be supplied as a precision die-cut part on rolls and can be formed as a foil-backed, nickel-plated base polymer with an electrically conductive and pressure-sensitive adhesive. No curing is required.

**GS8000 Nominal Properties**

| **Property** | **Nominal Value** | **Test Method** |
|---|---|---|
| Composite thickness | 1.62 ± 0.25 mm | Measured |
| Die-cut thickness | 1.0 mm¹ | Optically |
| Liner | 0.51 mm Polyester | N/A |
| Recommended compression stop | 0.3 to 0.5 mm (0.4 mm ideal) | N/A |
| Pressure to compress to 0.4 mm | 3.5 kg/cm² (50 psi) | EM2WIIN T-1055^{2,3} |
| DC resistance at 0.4 mm | 6mΩ | EM2WIIN T-1055^{2,3} |
| Volume resistivity at 0.4 mm | 0.03Ω-cm | Modified ASTM-D2739 |
| Shielding effectiveness at 0.4 mm (0.1 to 3 GHz) | >80 dB | Modified ARP-1705⁴ |

An example of relative dimensions for the antenna contact **600** is shown in FIG. 14. "X" could be about 4.2 mm. "Y" could be about 1.6 mm. "Z" could be about 1.5 mm.

This application is related to copending patent applications entitled, **"MOBILE WIRELESS COMMUNICATIONS DEVICE WITH RF IMMUNE CHARGING CONTACTS," and "MOBILE WIRELESS COMMUNICATIONS DEVICE WITH ANTENNA CONTACT HAVING REDUCED RF INDUCTANCE,"** which are filed on the same date and by the same assignee and inventors.

Many modifications and other embodiments will come to the mind of one skilled in the art having the benefit of the teachings presented in the foregoing descriptions and the associated drawings. Therefore, it is understood that various modifications and embodiments are intended to be included within the scope of the appended claims.

## Claims

1. A mobile wireless communications device, comprising:
a housing;
an antenna mounted within the housing;
radio frequency "RF" circuitry carried within the housing and comprising a transceiver connected to said antenna through which RF communications signals are transmitted and received, and a processor operative with the RF circuitry, wherein said transceiver further comprises an In-phase and Quadrature "I/Q" modulation and power amplification circuit comprising:
an In-phase "I" circuit (402) having an In-phase signal input, an In-phase modulator mixer (418), an In-phase power amplifier circuit (450a) that receives the In-phase signal and amplifies the In-phase signal and an In-phase controller (408a) connected to the output of the In-phase power amplifier circuit (450a) and operative in a closed loop manner with the In-phase power amplifier circuit (450a) to control biasing in the In-phase power amplifier circuit (450a) and to adjust the amplitude of the In-phase signal;
a Quadrature "Q" circuit (404) comprising a Quadrature signal input, a Quadrature modulator mixer (420), a Quadrature power amplifier circuit (450b) that receives the Quadrature signal and amplifies the Quadrature signal and a Quadrature controller (408b) connected to the output of the Quadrature power amplifier circuit (450b) and operative in a closed loop manner with the Quadrature power amplifier circuit (450b) to control biasing in the Quadrature power amplifier circuit (450b) and to adjust the amplitude of the Quadrature signal; and
a quadrature hybrid power combiner (460) that receives the separately amplified In-phase and Quadrature signals and sums and outputs the signals as a combined I and Q signal for further processing within the RF circuitry, wherein the I and Q signal inputs are isolated from the combined I and Q signal.

2. The mobile wireless communications device according to Claim 1,
wherein said quadrature hybrid power combiner comprises a 3 dB power combiner.

3. The mobile wireless communications device according to Claim 1,
wherein said quadrature hybrid power combiner is configured to reduce even order harmonics.

4. The mobile wireless communications device according to Claim 1,
wherein each power amplifier circuit (450a, 450b) is configured for about 30 dBm output as about one (1) watt output power.

5. The mobile wireless communications device according to Claim 1, and further comprising a local oscillator "LO" (430) and frequency divider (432) operative with each of said modulator mixers (418, 420) within respective I and Q circuits (402, 404).

6. The mobile wireless communications device according to Claim 1, which further comprises a bandpass filter (442a, 442b) connected between a respective modulator mixer (418, 420) and power amplifier circuit (450a, 450b) in each of said I and Q circuits (402, 404).

7. A method of operating a mobile wireless communications device which comprises a housing, an antenna mounted within the housing, at least one circuit board carried by the housing and including radio frequency "RF" circuitry carried by the at least one circuit board and comprising a transceiver connected to said antenna through which RF communications signals are transmitted and received, and a processor carried by the at least one circuit board and operative with the RF circuitry, the method comprising:
processing RF communications signals within the RF circuitry as In-phase "I" and Quadrature "Q" signals through an In-phase and Quadrature "I/Q" modulation and power amplification circuit by:
receiving In-phase signals within an In-phase circuit having a modulator mixer, amplifying only the In-phase signals with an In-phase power amplifier circuit and controlling biasing in the In-phase power amplifier circuit and adjusting the amplitude of the In-phase signal via an In-phase controller connected to the output of the In-phase power amplifier circuit, the In-phase controller operating in a closed loop manner with the In-phase power amplifier circuit;
receiving Quadrature signals within a Quadrature circuit comprising a modulator mixer, amplifying only the Quadrature signals with a Quadrature power amplifier circuit and controlling biasing in the Quadrature power amplifier circuit and adjusting the amplitude of the Quadrature signal via a Quadrature controller connected to the output of the Quadrature power amplifier circuit, the Quadrature controller operating in a closed loop manner with the Quadrature power amplifier circuit; and
power combining the separately amplified In-phase and Quadrature signals in a quadrature hybrid power combiner circuit that receives the separately amplified In-phase and Quadrature signals and sums and outputs the signals as a combined I and Q signal for further processing within the RF circuitry wherein the I and Q signal inputs are isolated from the combined I and Q signal.

8. The method according to Claim 7, which further comprises bandpass filtering each respective I and Q signal between a respective modulator mixer and power amplifier circuit.

9. The method according to Claim 7, which further comprises outputting about 3 dB at said power combiner.

10. The method according to Claim 7, which further comprises outputting about 30 dBm at each power amplifier circuit.

## Patentansprüche

1. Eine mobile drahtlose Kommunikationsvorrichtung, die aufweist:
ein Gehäuse;
eine Antenne, die in dem Gehäuse angebracht ist;
eine Funkfrequenz(RF - radio frequency)-Schaltung, die in dem Gehäuse getragen wird und einen Transceiver, der mit der Antenne verbunden ist,
über die RF-Kommunikationssignale gesendet und empfangen werden, und
einen Prozessor aufweist, der mit der RF-Schaltung betriebsfähig ist, wobei der Transceiver weiter eine phasengleiche und Quadratur(I/Q - In-phase/Quadrature)-Modulations- und Leistungsverstärkungsschaltung aufweist, die aufweist:
eine phasengleiche (I - In-phase) Schaltung (402) mit einem phasengleichen Signaleingang, einem phasengleichen Modulatormischer (418), einer phasengleichen Leistungsverstärkungsschaltung (450a), die das phasengleiche Signal empfängt und das phasengleiche Signal verstärkt, und eine phasengleiche Steuervorrichtung (408a), die mit dem Ausgang der phasengleichen Leistungsverstärkungsschaltung (450a) verbunden ist und auf eine "geschlossene Schleife"-Weise mit der phasengleichen Leistungsverstärkungsschaltung (450a) betriebsfähig ist, um ein Biasing in der phasengleichen
Leistungsverstärkungsschaltung (450a) zu steuern und die Amplitude des phasengleichen Signals anzupassen;
eine Quadratur(Q - Quadrature)-Schaltung (404), die einen Quadratur-Signaleingang, einen Quadratur-Modulatormischer (420), eine Quadratur-Leistungsverstärkungsschaltung (450b), die das Quadratur-Signal empfängt und das Quadratur-Signal verstärkt, und
eine Quadratur-Steuervorrichtung (408b) aufweist, die mit dem Ausgang der Quadratur-Leistungsverstärkungsschaltung (450b) verbunden ist und auf eine "geschlossene Schleife"-Weise mit der Quadratur-Leistungsverstärkungsschaltung (450b) betriebsfähig ist,
um ein Biasing in der Quadratur-Leistungsverstärkungsschaltung (450b) zu steuern und die Amplitude des Quadratur-Signals anzupassen; und
einen Quadratur-Hybrid-Leistungskombinierer (460), der die getrennt verstärkten phasengleichen und Quadratur-Signale empfängt und die Signale summiert und als ein kombiniertes I- und Q-Signal ausgibt zur weiteren Verarbeitung in der RF-Schaltung, wobei die I- und Q-Signaleingänge von dem kombinierten I- und Q-Signal isoliert sind.

2. Die mobile drahtlose Kommunikationsvorrichtung gemäß Anspruch 1, wobei der Quadratur-Hybrid-Leistungskombinierer einen 3-dB-Leistungskombinierer aufweist.

3. Die mobile drahtlose Kommunikationsvorrichtung gemäß Anspruch 1, wobei der Quadratur-Hybrid-Leistungskombinierer konfiguriert ist zum Reduzieren von geradzahligen Harmonischen.

4. Die mobile drahtlose Kommunikationsvorrichtung gemäß Anspruch 1, wobei jede Leistungsverstärkungsschaltung (450a, 450b) konfiguriert ist für ungefähr einen 30dBm-Ausgang als ungefähr ein (1) Watt Ausgangsleistung.

5. Die mobile drahtlose Kommunikationsvorrichtung gemäß Anspruch 1, und weiter aufweisend einen lokalen Oszillator (LO - local oscillator) (430) und einen Frequenzteiler (432), betriebsfähig mit jedem der Modulatormischer (418, 420) in jeweiligen I- und Q-Schaltungen (402, 404).

6. Die mobile drahtlose Kommunikationsvorrichtung gemäß Anspruch 1, die weiter einen Bandpassfilter (442a, 442b) aufweist, der zwischen einem jeweiligen Modulatormischer (418, 420) und einer Leistungsverstärkungsschaltung (450a, 450b) in jeder der I- und Q-Schaltungen (402, 404) verbunden ist.

7. Ein Verfahren zum Betreiben einer mobilen drahtlosen Kommunikationsvorrichtung, die aufweist ein Gehäuse, eine Antenne, die in dem Gehäuse angebracht ist, zumindest eine Leiterplatte, die von dem Gehäuse getragen wird und eine Funkfrequenz(RF - radio frequency)-Schaltung umfasst, die von der zumindest einen Leiterplatte getragen wird und einen Transceiver, der mit der Antenne verbunden ist, über die RF-Kommunikationssignale gesendet und empfangen werden, und einen Prozessor aufweist, der von der zumindest einen Leiterplatte getragen wird und mit der RF-Schaltung betriebsfähig ist, wobei das Verfahren aufweist:
Verarbeiten von RF-Kommunikationssignalen in der RF-Schaltung als phasengleiche (I - In-phase) und Quadratur(Q - Quadrature)-Signale durch eine phasengleiche und Quadratur(I/Q - In-phase/Quadrature)-Modulationsund Leistungsverstärkungsschaltung durch:
Empfangen von phasengleichen Signalen in einer phasengleichen Schaltung mit einem Modulatormischer, Verstärken nur der phasengleichen Signale mit einer phasengleichen Leistungsverstärkungsschaltung und Steuern eines Biasing in der phasengleichen Leistungsverstärkungsschaltung und Anpassen der Amplitude des phasengleichen Signals mit einer phasengleichen Steuervorrichtung, die mit dem Ausgang der phasengleichen Leistungsverstärkungsschaltung verbunden ist, wobei die phasengleiche Steuervorrichtung auf eine "geschlossene Schleife"-Weise mit der phasengleichen Leistungsverstärkungsschaltung arbeitet;
Empfangen von Quadratur-Signalen in einer Quadratur-Schaltung, die einen Modulatormischer aufweist, Verstärken nur der Quadratur-Signale mit einer Quadratur-Leistungsverstärkungsschaltung und Steuern eines Biasing in der Quadratur-Leistungsverstärkungsschaltung und Anpassen der Amplitude des Quadratur-Signals mit einer Quadratur-Steuervorrichtung, die mit dem Ausgang der Quadratur-Leistungsverstärkungsschaltung verbunden ist, wobei die Quadratur-Steuervorrichtung auf eine "geschlossene Schleife"-Weise mit der Quadratur-Leistungsverstärkungsschaltung arbeitet; und
Leistungs-Kombinieren der getrennt verstärkten phasengleichen und
Quadratur-Signale in einer Quadratur-Hybrid-Leistungskombiniererschaltung, die die getrennt verstärkten phasengleichen und Quadratur-Signale empfängt und die Signale summiert und als ein kombiniertes I- und Q-Signal ausgibt zur weiteren Verarbeitung in der RF-Schaltung, wobei die I- und Q-Signaleingänge von dem kombinierten I- und Q-Signal isoliert sind.

8. Das Verfahren gemäß Anspruch 7, das weiter ein Bandpassfiltern jedes jeweiligen I- und Q-Signals zwischen einem jeweiligen Modulatormischer und einer Leistungsverstärkungsschaltung aufweist.

9. Das Verfahren gemäß Anspruch 7, das weiter ein Ausgeben von ungefähr 3 dB an dem Leistungskombinierer aufweist.

10. Das Verfahren gemäß Anspruch 7, das weiter ein Ausgeben von ungefähr 30 dBm an jeder Leistungsverstärkungsschaltung aufweist.

## Revendications

1. Dispositif de communication mobile sans fil, comprenant :
un boîtier ;
une antenne montée dans le boîtier ;
une circuiterie pour radiofréquences, RF, logée dans le boîtier et comprenant un émetteur-récepteur connecté à ladite antenne, grâce auquel des signaux de communication RF sont émis et reçus, et un processeur coopérant avec la circuiterie RF, dans lequel ledit émetteur-récepteur comprend en outre un circuit de modulation en phase et en quadrature, I/Q, et d'amplification de puissance comprenant :
un circuit en phase, I, (402) ayant une entrée de signal en phase, un mélangeur-modulateur en phase (418), un circuit amplificateur de puissance en phase (450a), qui reçoit le signal en phase et amplifie le signal en phase, et un contrôleur en phase (408a) connecté à la sortie du circuit amplificateur de puissance en phase (450a) et fonctionnant en boucle fermée avec le circuit amplificateur de puissance en phase (450a) afin de commander la polarisation dans le circuit amplificateur de puissance en phase (450a) et d'ajuster l'amplitude du signal en phase ;
un circuit en quadrature, Q, (404) comprenant une entrée de signal en quadrature, un mélangeur-modulateur en quadrature (420), un circuit amplificateur de puissance en quadrature (450b), qui reçoit le signal en quadrature et amplifie le signal en quadrature, et un contrôleur en quadrature (408b) connecté à la sortie du circuit amplificateur de puissance en quadrature (450b) et fonctionnant en boucle fermée avec le circuit amplificateur de puissance en quadrature (450b) afin de commander la polarisation dans le circuit amplificateur de puissance en quadrature (450b) et d'ajuster l'amplitude du signal en quadrature ; et
un combinateur de puissance hybride en quadrature (460) qui reçoit les signaux en phase et en quadrature amplifiés séparément, les additionne et produit en sortie les signaux sous la forme d'un signal combiné I et Q pour la suite du traitement dans la circuiterie RF, les signaux I et Q étant isolés du signal I et Q combiné.

2. Dispositif de communication mobile sans fil selon la revendication 1, dans lequel ledit combinateur de puissance hybride en quadrature comprend un combinateur de puissance de 3dB.

3. Dispositif de communication mobile sans fil selon la revendication 1, dans lequel ledit combinateur de puissance hybride en quadrature est configuré pour réduire les harmoniques d'ordre pair.

4. Dispositif de communication mobile sans fil selon la revendication 1, dans lequel chaque circuit amplificateur de puissance (450a, 450b) est configuré pour une sortie d'environ 30 dBm sous la forme d'une puissance de sortie d'environ 1 Watt.

5. Dispositif de communication mobile sans fil selon la revendication 1 et comprenant en outre un oscillateur local (430) et un diviseur de fréquence (432) coopérant avec chacun desdits mélangeurs-modulateurs (418, 420) dans les circuits I et Q (402, 404) respectifs.

6. Dispositif de communication mobile sans fil selon la revendication 1, comprenant en outre un filtre passe-bande (442a, 442b) connecté entre un mélangeur-modulateur (418, 420) et un circuit amplificateur de puissance (450a, 450b) dans chacun desdits circuits I et Q (402, 404), respectivement.

7. Procédé de fonctionnement d'un dispositif de communication mobile sans fil comprenant un boîtier, une antenne montée dans le boîtier, au moins une carte de circuits imprimés supportée dans le boîtier et portant une circuiterie pour radiofréquences RF portée par ladite carte de circuits imprimés et comprenant un émetteur-récepteur connecté à ladite antenne, grâce auquel des signaux de communication RF sont émis et reçus, et un processeur porté par ladite carte de circuits imprimés et coopérant avec la circuiterie RF, le procédé comprenant les étapes consistant à :
traiter les signaux de communication RF dans ladite circuiterie RF sous la forme de signaux en phase, I, et de signaux en quadrature, Q, traversant un circuit de modulation et d'amplification de puissance en phase et en quadrature, I/Q, en exécutant les étapes consistant à :
recevoir des signaux en phase sur un circuit en phase comprenant un mélangeur-modulateur, amplifier les seuls signaux en phase à l'aide d'un circuit amplificateur de puissance en phase, commander la polarisation dans le circuit amplificateur de puissance en phase et ajuster l'amplitude du signal en phase à l'aide d'un contrôleur en phase connecté à la sortie du circuit amplificateur de puissance en phase, le contrôleur en phase fonctionnant en boucle fermée avec le circuit amplificateur de puissance en phase ;
recevoir des signaux en quadrature sur un circuit en quadrature comprenant un mélangeur-modulateur, amplifier les seuls signaux en quadrature à l'aide d'un circuit amplificateur de puissance en quadrature, commander la polarisation dans le circuit amplificateur de puissance en quadrature et ajuster l'amplitude du signal en quadrature à l'aide d'un contrôleur en quadrature connecté à la sortie du circuit amplificateur de puissance en quadrature, le contrôleur en quadrature fonctionnant en boucle fermée avec le circuit amplificateur de puissance en quadrature ; et
effectuer la combinaison de puissance des signaux en phase et en quadrature amplifiés séparément dans un circuit combinateur de puissance hybride en quadrature qui reçoit les signaux en phase et en quadrature amplifiés séparément, les additionne et produit en sortie les signaux sous la forme d'un signal combiné I et Q pour la suite du traitement dans la circuiterie RF, les signaux I et Q étant isolés du signal I et Q combiné.

8. Procédé selon la revendication 7, comprenant en outre une étape de filtrage passe-bande sur chacun des signaux I et Q respectifs entre un mélangeur-modulateur et un circuit amplificateur de puissance, respectivement.

9. Procédé selon la revendication 7, comprenant en outre l'étape consistant à produire en sortie environ 3 dB au niveau dudit combinateur de puissance.

10. Procédé selon la revendication 7, comprenant en outre l'étape consistant à produire environ 30 dBm au niveau de chaque circuit amplificateur de puissance.
